# EUROPÄISCHE PATENTSCHRIFT

(11) **EP 1 784 864 B1**
(45) Veröffentlichungstag und Bekanntmachung des Hinweises auf die Patenterteilung: **27.10.2010**
(21) Anmeldenummer: 05779239.2
(22) Anmeldetag: 25.08.2005
(51) Int. Cl.: H01L 25/16, H01L 23/367, H01L 23/495, H01L 25/10

(54) **ELEKTRISCHE BAUGRUPPE**
ELECTRIC SUB-ASSEMBLY
MODULE ELECTRIQUE

(30) Priorität: 31.08.2004 DE 102004042488
(43) Veröffentlichungstag der Anmeldung: 16.05.2007
(73) Patentinhaber: Continental Automotive GmbH, 30165 Hannover (DE)
(72) Erfinder: WALLRAFEN, Werner, 65719 Hofheim (DE)
(86) Internationale Anmeldenummer: PCT/EP2005/054189
(87) Internationale Veröffentlichungsnummer: WO 2006/024626

(56) Entgegenhaltungen:
- DE-A1- 3 940 933
- DE-A1- 4 031 051
- DE-A1- 10 334 761
- GB-A- 1 255 073
- GB-A- 1 285 735
- US-A- 5 770 973
- US-A1- 2003 153 128
- US-A1- 2005 180 116

## Beschreibung

Die Erfindung betrifft eine elektrische Baugruppe mit einer integrierten Schaltung, die mindestens ein Leistungshalbleiterelement und weitere elektronische Bauelementen aufweist, die durch von einem Gitterblech gebildete Leiter miteinander und mit Anschlüssen verbunden sind, wobei das Gitterblech mindestens eine Kühlfläche aufweist, die mit einer thermischen Kontaktfläche der mindestens einen integrierten Schaltung thermisch leitend verbunden ist, die eine größere Fläche als die thermische Kontaktfläche der mindestens einen integrierten Schaltung aufweist und die breiter als die zur elektrischen Leitung verwendeten Teile des Gitterblechs ist und wobei die Kühlfläche als thermisches Kontaktblech mit an seinem der integrierten Schaltung abgewandten Ende aus seiner Ebene abgebogener Anschlusslasche ausgebildet ist, an der ein Ende der Kontaktfläche in Anlage und thermisch leitend verbunden ist.

Elektrische Baugruppen, die zuverlässig arbeiten sollen und robust gegenüber Umwelteinflüssen sein müssen, werden häufig mit Hilfe von Leadframe-Strukturen (Gitterblech) realisiert, auf welche aktive und passive elektrische und elektronische Bauelemente durch Schweissen aufgebracht sind. Die Baugruppen werden mit elektrisch isolierenden Werkstoffen umkapselt, so dass sie hermetisch gegenüber Umwelteinflüssen abgeschlossen sind und auch grossen mechanischen Belastungen (Stoss, Vibration) widerstehen können. Beispiele für solche Baugruppen sind Drehzahlsensoren oder Positionssensoren in Kraftfahrzeugen.

Bei der Verwendung von Leistungshalbleiterelementen, insbesondere Feldeffekttransistoren, entstehen jedoch mitunter grosse Verlustleistungen, die bei den beschriebenen Baugruppen schwer abzuführen sind.

Elektrische Baugruppen der eingangs genannten Art sind aus der US-A-5 770 973, der DE 103 34 761 A1, und der DE 40 31 051 A1 bekannt.

Aus der DE 39 40 933 A1 ist eine elektrische Baugruppe bekannt, bei der eine Kontaktfläche eines Gitterblechs im Bereich gegen eine Kühlfläche vorgespannt ist.

Aus der GB-A-1 255 073 ist es bekannt ein Gitterblech einer elektrischen Baugruppe in einem elektrisch isolierenden Halterahmen zu lagern.

Abgebogene Anschlußlaschen zur Anlage an einer Kontaktfläche bei einer elektrischen Baugruppe mit einem Gitterblech sind aus der GB-A-1 285 735 bekannt.

Aufgabe der vorliegenden Erfindung ist es, eine elektrische Baugruppe der eingangs genannten Art derart zu gestalten, dass bei Beibehaltung der positiven Eigenschaften und möglichst geringen zusätzlichen Kosten eine gute Wärmeableitung möglich ist und ein Aufbau über Flachbaugruppen (Epoxi-Leiterplatten oder Keramikplatten in SO-Technologie) mit separaten Kühlelementen vermieden wird.

Diese Aufgabe wird bei der erfindungsgemässen Baugruppe dadurch gelöst, das thermische Kontaktblech in ein Bauteil aus einem elektrisch isolierenden Werkstoff eingespritzt oder eingegossen ist, wobei das Bauteil eine Aufnahme aufweist, in die die integrierte Schaltung derart positioniert einsetzbar ist, dass Anschlusslasche und Gegenanschlusslasche sowie Signalanschlusslaschen und Signalgegenanschlusslaschen aneinander in Anlage sind.

Durch diese Ausbildung wird durch das Einsetzen der integrierten Schaltung in die Aufnahme gleichzeitig ein richtig zugeordnetes aneinander Anliegen von Anschlusslaschen und Gegenanschlusslaschen sowie Signalanschlusslaschen und Signalgegenanschlusslaschen erreicht, was den Montagevorgang wesentlich vereinfacht.

Dadurch, daß die Kühlfläche als thermisches Kontaktblech mit an seinem der integrierten Schaltung abgewandten Ende aus seiner Ebene abgebogener Anschlusslasche ausgebildet ist, an der ein Ende der Kontaktfläche in Anlage und thermisch leitend verbunden ist, so ist sowohl eine einfache Montierbarkeit der integrierten Schaltung als auch eine einfache Diagnose bei einem Defekt der Baugruppe möglich.

Zum leitenden Verbinden wird eine gute Zugänglichkeit z. B. zum Schweissen erreicht, wenn Anschlusslasche und Gegenanschlusslasche und/oder Signalanschlusslaschen und Signalgegenanschlusslaschen von der Ebene eines Bodens der Aufnahme weggerichtet abgebogen sind.

Ist das thermische Kontaktblech derart in das Bauteil aus elektrisch isolierendem Werkstoff eingespritzt oder eingegossen, dass mindestens 50 % der Fläche des Kontaktblechs mit einer Wandstärke des elektrisch isolierenden Werkstoffs von < 3 mm, insbesondere von < 1,5 mm bedeckt ist, so wird eine gute Wärmeableitung von dem thermischen Kontaktblech über das Bauteil aus elektrisch isolierendem Werkstoff bei gleichzeitig guter Stabilität der Baugruppe erreicht.

Sind die signalführenden Leiter des Gitterblechs in das Bauteil aus elektrisch isolierendem Werkstoff eingespritzt oder eingegossen, und die integrierte Schaltung derart positioniert in die Aufnahme einsetzbar, dass einander zugeordnete Signalanschlusslaschen und Signalgegenanschlusslaschen aneinander in Anlage sind, so ist auch hier eine einfache exakte Positionierung der Signalanschlusslaschen zu den Signalgegenanschlusslaschen bei der Montage möglich.

Zur weiteren Ableitung der von der integrierten Schaltung erzeugten Wärme kann die integrierte Schaltung mit einer Begrenzungswand an dem Boden der Aufnahme in Anlage sein, wobei vorzugsweise das Bauteil aus elektrisch isolierendem Werkstoff im Bereich des Bodens der Aufnahme eine Wandstärke von < 4 mm, insbesondere von < 2 mm besitzt. Je geringer die Wandstärke, desto besser ist die Wärmeableitungsfähigkeit zur Umgebungsluft.

Dabei kann die integrierte Schaltung über eine Zwischenschicht an dem Boden der Aufnahme in Anlage sein.

Zur guten Wärmeübertragung ist es möglich, dass die Zwischenschicht aus einem wärmeleitenden Klebstoff, einer wärmeleitenden Klebefolie oder einer Wärmeleitpaste besteht.

Ist das thermische Kontaktblech in seinem von dem elektrisch isolierenden Werkstoff umschlossenen Bereich mit einer Ausnehmung oder einer Mehrzahl, insbesondere einer Vielzahl durchgehender Ausnehmungen versehen, so wird durch den die Ausnehmungen ausfüllenden elektrisch isolierenden Werkstoff auch bei Temperaturwechsel eine zumindest weitgehend sichere Anlage des Kontaktblechs an dem Kunststoff erreicht. Delaminationen zwischen diesen Teilen, die nach einem TemperaturWechsel auftreten und zu einer isolierenden Luftschicht zwischen diesen Teilen führen könnten, werden so einfach vermieden.

Vorzugsweise wird das Gitterblech aus einem Blech einstückig ausgestanzt. Teile des Gitterblechs dienen der elektrischen Verbindung, andere Teile zur Kühlung. Die thermische Verbindung zwischen der Kontaktfläche und der Kühlfläche kann auf verschiedene Weise erfolgen, beispielsweise durch Leitkleber, durch Schweissen oder Löten. Es kann jedoch auch eine federelastische Klemmung vorgesehen sein. Die Kühlfläche kann im Einzelfall an die Masse bzw. den Minuspol der Betriebsspannungsquelle angeschlossen sein.

Zur Erzielung eines guten thermischen Kontaktes ist bei einer Weiterbildung der erfindungsgemässen Baugruppe vorgesehen, dass die Kühlfläche mit der Kontaktfläche an mindestens zwei gegenüber liegenden Kanten fest verbunden ist und dass der an der Kontaktfläche anliegende Flächenbereich der Kühlfläche gegen die Kontaktfläche vorgespannt ist. Dabei wird vorausgesetzt, dass die Stärke des Kühlbleches geringer ist als die Stärke des Metallkörpers des integrierten Schaltkreises, der die Kontaktfläche bildet.

Eine vorteilhafte Ausgestaltung der erfindungsgemässen Baugruppe besteht darin, dass die Baugruppe einschliesslich des Gitterblechs mit einem elektrisch isolierenden Werkstoff umkapselt ist. Die Baugruppe kann mit kühlender Luft in Verbindung gebracht werden.

Um dabei jedoch eine gute Wärmeableitung von der Kühlfläche zu dem umgebenden Medium zu gewährleisten, kann bei dieser Ausgestaltung vorgesehen sein, dass die Kühlfläche mindestens teilweise nicht umkapselt ist oder dass die Kühlfläche mindestens teilweise mit einer dünneren Schicht umkapselt list als die übrigen Teile der Baugruppe.

Eine andere vorteilhafte Ausführungsform ermöglicht eine universelle Verwendung-der erfindungsgemässen Baugruppe dadurch, dass die weiteren elektronischen Bauelemente eine applikationsspezifische integrierte Schaltung bilden.

Ausserdem kann bei der erfindungsgemässen Baugruppe vorgesehen sein, dass ein Sensor, insbesondere ein Positionserfassungssensor mit Hilfe der vom Gitterblech gebildeten Leiter angeschlossen ist.

Eine besonders kompakte Baugruppe wird dadurch erzielt, dass die applikationsspezifische integrierte Schaltung und die integrierten Schaltungen in einem gemeinsamen Gehäuse integriert sind.

Zur Stabilität im Fertigungsprozess trägt ferner bei, dass das Gitterblech in einem elektrisch isolierenden Halterahmen gelagert ist.

Zur elektrischen Verbindung mit anderen Baugruppen und Geräten kann gemäss einer vorteilhaften Ausgestaltung vorgesehen sein, dass Teile des Gitterblechs als elektrische Steckverbindungen ausgeführt sind.

Zur Verbesserung der Wärmeableitung kann ferner vorgesehen sein, dass zwischen der Kontaktfläche und dem diese berührenden Bereich des Gitterblechs eine wärmeleitende Zwischenschicht aufgebracht ist.

Diese einfache Montierbarkeit wird noch verbessert, wenn die Kontaktfläche eine Gegenanschlusslasche aufweist die an der Anschlusslasche Anschlusslasche des thermischen Kontaktblechs in Anlage und mit der Anschlusslasche thermisch leitend verbunden ist.

Eine Verschweißung kann z.B. einfach nach Fertigstellung des Bauteils der Baugruppe erfolgen.

Die gleichen Vorteile werden weiterhin erreicht, wenn das Gitterblech signalführende Leiter, aufweist, die an ihren der integrierten Schaltung zugewandten Enden aus ihrer Ebene abgebogene Signalanschlusslaschen aufweisen, an denen Enden die signalführenden Leiter in Anlage und elektrisch leitend verbunden sind und wenn die Enden der signalführenden Leiter Signalgegenanschlusslaschen aufweisen, die an den Signalanschlusslaschen in Anlage und elektrisch leitend verbunden sind.

Sowohl eine gute Wärmeleitung als auch eine gute elektrische Leitung wird dadurch erreicht, dass die Anschlusslasche mit der Gegenanschlusslasche und/oder die Signalanschlusslaschen mit den Signalgegenanschlusslaschen durch Schweissen wie elektrisches Widerstandsschweissen oder Laserschweissen oder durch Löten verbunden sind.

Eine gute Wärmeleitung kann auf einfache Weise auch dadurch erreicht werden, dass die Anschlusslasche mit der Gegenanschlusslasche mittels elektrisch- und/oder wärmeleitfähigem Kleber verbunden ist.

Zur guten elektrischen Leitung können in einfacher Weise die Signalanschlusslaschen mit den Signalgegenanschlusslaschen mittels einem elektrisch leitfähigen Kleber verbunden sein.

Die integrierte Schaltung kann ein mit Kunststoff umkapseltes Leistungshalbleiterelement oder eine auf einem Substrat angeordnete, Leistungshalbleiterelemente aufweisende Hybridschaltung sein.

Dabei ist das Substrat vorzugsweise ein Keramiksubstrat oder ein isoliertes Metallsubstrat oder eine Epoxi-Leiterplatte, auf dem das Leistungshalbleiterelement und elektronische Bauteile angeordnet, insbesondere aufgelötet oder insbesondere thermisch leitfähig aufgeklebt sind.

Die Erfindung lässt zahlreiche Ausführungsformen zu. Mehrere davon sind schematisch in der Zeichnung anhand mehrerer Figuren dargestellt und nachfolgend beschrieben. Es zeigt:
Fig. 1 eine erste Ansicht eines Ausführungsbeispiels,
Fig. 2 eine zweite Ansicht von Teilen des Ausführungsbeispiels nach Fig. 2,
Fig. 3 und Fig. 4 je einen Querschnitt durch einen Teil eines Ausführungsbeispiels, bei welchem durch Vorbiegen der Kühlfläche ein guter thermischer Kontakt erzielt wird in einer ersten Phase bei der Herstellung und im Fertigzustand,
Fig. 5 ein Ausführungsbeispiel mit einer Umkapselung aus Kunststoff
Fig. 6 ein weiteres Ausführungsbeispiel mit einer Umkapselung.
Fig. 7 eine perspektivische Ansicht eines weiteren Ausführungsbeispiels
Fig. 8 eine perspektivische Ansicht eines weiteren Ausführungsbeispiels und
Fig. 9 eine perspektivische Ansicht eines weiteren Ausführungsbeispiels
Fig. 10 eine stilisierte Draufsicht eines Gitterblechs mit angeschlossener Schaltung, Motor und Sensor.

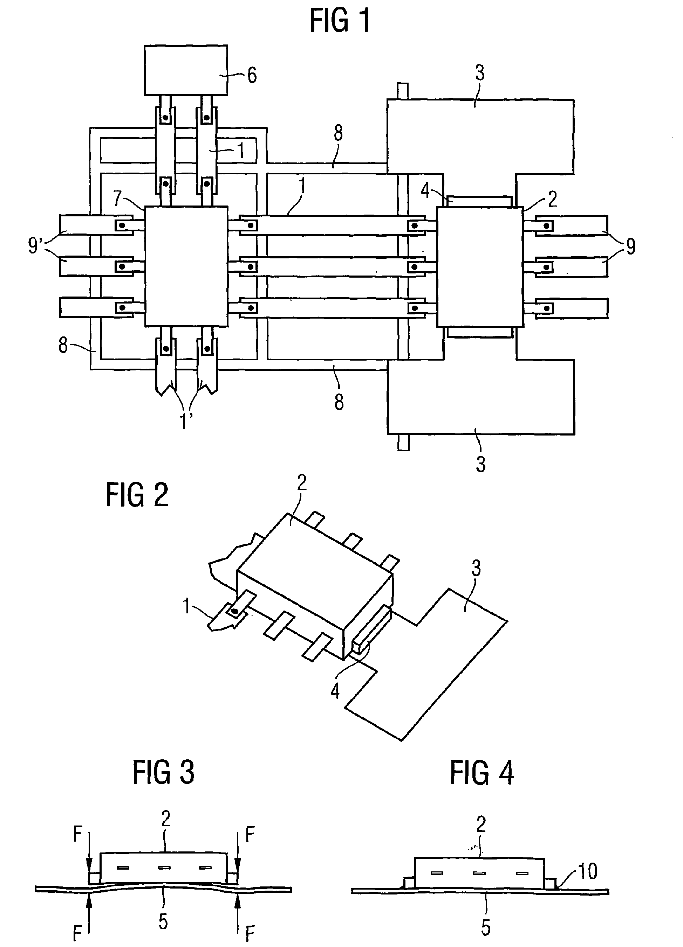

Bei dem Ausführungsbeispiel nach den Figuren 1 und 2 verbinden Leiter 1 eines Gitterblechs eine Baueinheit, die als integrierte Schaltung ausgebildet ist und mehrere Leistungshalbleiterelemente 2 umfasst, mit einer applikationsspezifischen integrierten Schaltung 7 und einem Sensor 6. Weitere Leiter des Gitterblechs sind aus der Baugruppe herausgeführt und dienen als Anschlussstifte 9, 9'. Ein breiterer Leiter des Gitterblechs ist flächenartig erweitert und bildet eine Kühlfläche 3, die mit einer thermischen Kontaktfläche 4 der integrierten Schaltung 2 in Wärmekontakt steht. Die Anschlussstifte 9 dienen zur Verbindung mit einem Motor, vorzugsweise über Entstördrosseln, die in Fig. 1 nicht dargestellt sind. Mit den abgebrochen dargestellten Leitern 1' soll gezeigt werden, dass noch andere Bauelemente in der erfindungsgemäßen Baugruppe vorhanden sein können.

Bei der Herstellung wird ein Gitterblech zunächst als ein Stück hergestellt. Später werden vorhandene Brücken zwischen den einzelnen Leitern 1, 1' aufgetrennt. Dadurch kann das Gitterblech bis zu einer Festlegung der Leiter als ein Stück gehandhabt werden. Das Auftrennen erfolgt erst, wenn die einzelnen Leiter fixiert sind, was bei dem Ausführungsbeispiel nach Fig. 1 durch einen Halterahmen 8 erfolgt. Eine endgültige Fixierung erfolgt dann, wenn die gesamte Baugruppe mit elektrisch isoliertem Werkstoff umkapselt ist.

Bei dem Ausführungsbeispiel nach Fig. 3 ist ein Flächenbereich 5 eines Leiters des Gitterblechs auf derjenigen Fläche, welche die Kontaktfläche 4 des Leistungshalbleiterelements 2 berühren soll, vorgebogen. Bei der Montage wird der Flächenbereich 5 an die Kontaktfläche 4 angepresst und fixiert, beispielsweise durch eine Löt- oder Schweissnaht 10 oder durch geeignete Klammern. Durch die Vorspannung liegt der Leiter im Flächenbereich 5 fest an der ganzen Kontaktfläche 4 an.

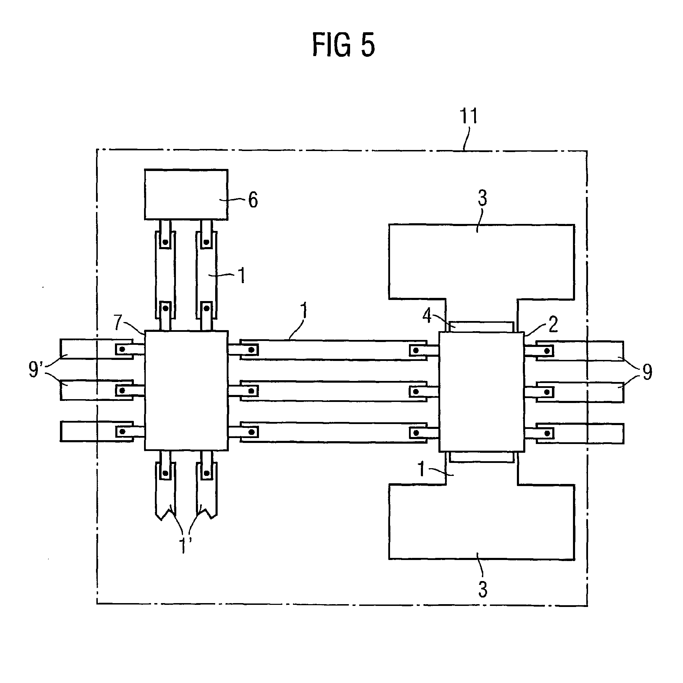

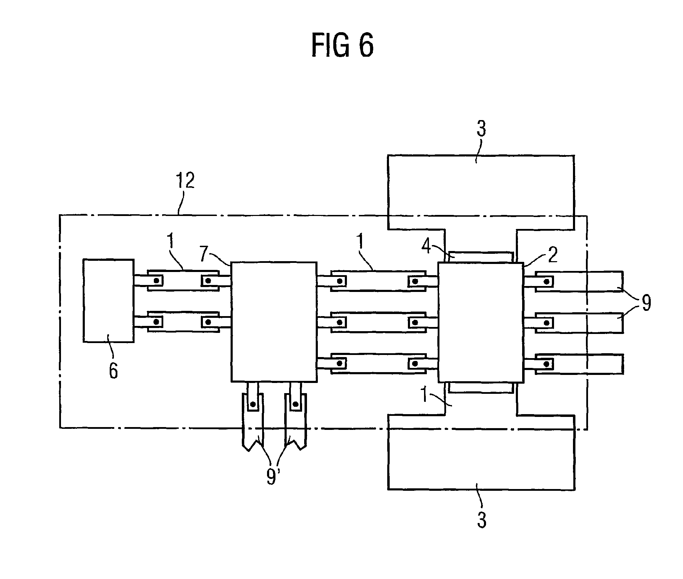

Das Ausführungsbeispiel nach Fig. 5 weist eine Kapselung 11 auf, die auch die Kühlfläche 3 umfasst und durchsichtig dargestellt ist, um den Blick auf die Bauelemente und Leiter frei zu geben. Um eine höhere Wärmeableitung zu erzielen, sind bei dem Ausführungsbeispiel nach Fig. 6 die Kühlflächen 3 nicht von der Kapselung 12 umschlossen.

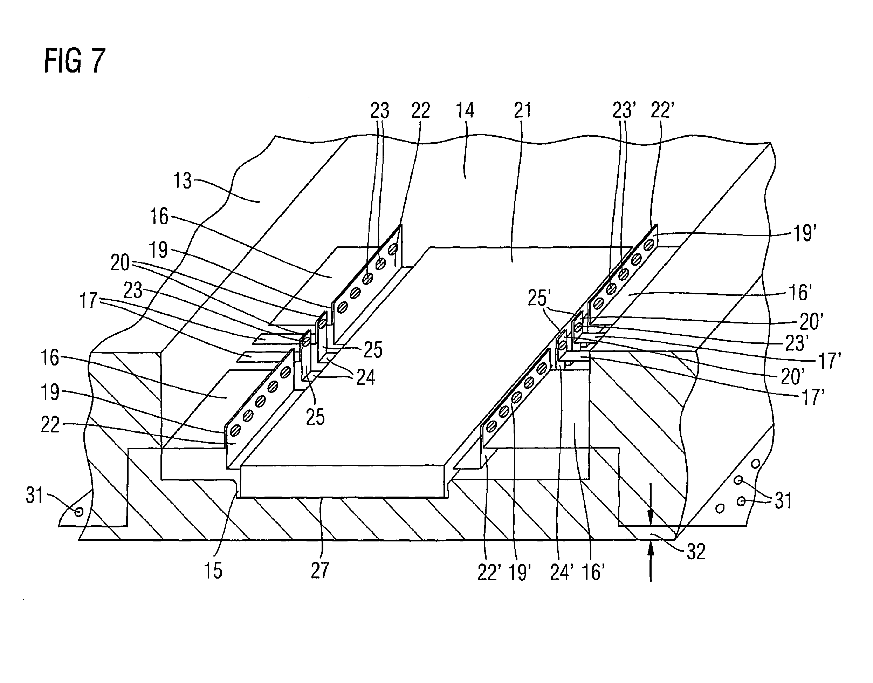

Die in den Figuren 7 bis 9 dargestellten Ausführungsbeispiele zeigen ein etwa topfartiges Bauteil 13 aus einem elektrisch isolierenden Werkstoff, der ein Kunststoff ist und ein Epoxiharz, ein Thermoplast oder ein Duroplast sein kann.

Das Gehäuseteil 13 kann ein Gehäusedeckel eines Gehäuses eines Drosselklappenventils für ein Kraftfahrzeug sein.

Am Grund der topfartigen Vertiefung 14 des Bauteils 13 ist eine vertiefte Aufnahme 15 rechteckigen Querschnitts ausgebildet.

In den Kunststoff ist ein Gitterblech mit eingespritzt, das aus thermischen Kontaktblechen 16, 16' und signalführenden Leiter 17, 17' besteht.

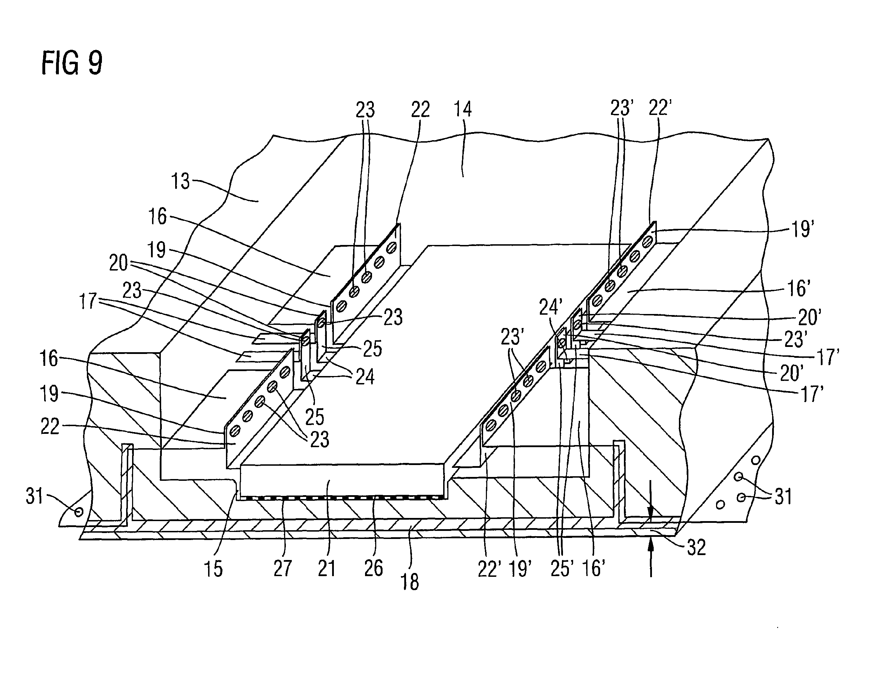

Bei dem Ausführungsbeispiel der Figur 9 ist das Gitterblech zunächst mit einer Vorumspritzung 18 aus Kunststoff versehen worden, um dann in einem weiteren Arbeitsgang noch einmal zum Bauteil 13 umspritzt zu werden.

Jeweils zwei Kontaktbleche 16 und zwei Leiter 17 ragen nebeneinanderliegend aus der Seitenwand der Vertiefung 14 des Bauteils Bauteils 13.

Diesen zwei Kontaktblechen 16 und Leitern 17 gegenüberliegend ragen ebenfalls zwei Kontaktbleche 16' und zwei Leiter 17' aus Seitenwand der Vertiefung 14 des Bauteils 13.

Die in die Vertiefung 14 ragenden freien Enden der Kontaktbleche 16, 16' sind rechtwinklig aus der Ebene der Kontaktbleche 16, 16' heraus zu Anschlusslaschen 19, 19' abgebogen. In gleicher Weise sind auch die in die Vertiefung 14 ragenden freien Enden der Leiter 17, 17' rechtwinklig aus der Ebene der Leiter 17, 17' heraus zu Signalanschlusslaschen 20, 20' abgebogen.

Sowohl die Anschlusslaschen 19, 19' als auch die Signalanschlusslaschen 20, 20' sind zur Öffnung der Vertiefung 14 hin gerichtet.

In die Aufnahme 15 ist eine integrierte Schaltung etwa gleicher Querschnittskontur wie die Aufnahme 15 eingesetzt, die in Figur 9 mittels eines wärmeleitenden Klebers 26 mit dem Boden 27 der Aufnahme 15 verbunden ist.

Bei den Ausführungsbeispielen der Figuren 7 und 9 sind parallel zu den Kontaktblechen 16, 16' blechartige Kontaktflächen 4 aus den den Kontaktblechen 16, 16' zugewandten Seiten der umkapselten integrierten Schaltung 21 herausgeführt und an ihren freien Enden zur Öffnung der Vertiefung 14 hin gerichtet zu Gegenanschlusslaschen 22, 22' rechtwinklig abgebogen.

Jeder Anschlusslasche 19, 19' ist eine Gegenanschlusslasche 22, 22' zugeordnet. Dabei besitzen einander zugeordnete Anschlusslaschen 19, 19' und Gegenanschlusslaschen 22, 22' gleiche Breite, sind in gleiche Richtung gerichtet und liegen aneinander an.

Durch mehrere Schweisspunkte 23 sind die einander zugeordneten Anschlusslaschen 19, 19' und Gegenanschlusslaschen 22, 22' elektrisch und thermisch leitend miteinander verbunden.

In gleicher Weise, wie die Gegenanschlusslaschen 22, 22' sind auch blechartige Signalleiter 24, 24' aus der integrierten Schaltung 21 herausgeführt und zu Signalgegenanschlusslaschen 25, 25' abgebogen, die an den Signalanschlusslaschen 20, 20' in Anlage und durch Schweisspunkte 23' mit diesen elektrisch leitend verbunden sind.

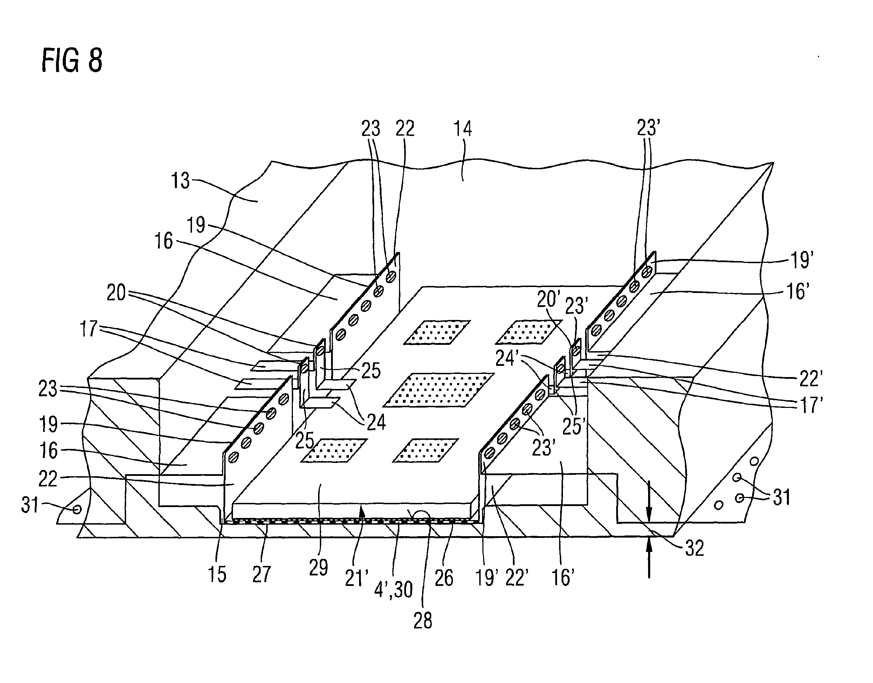

Bei dem Ausführungsbeispiel der Figur 8 sind blechartige Kontaktflächen 4' vorhanden, die entsprechend der Aufnahme 15 zu einem "U" gebogen und in die Aufnahme 15 eingesetzt sind.

Mittels eines wärmeleitfähigen Klebers 26 sind die Kontaktflächen 4' an dem Boden 27 der Aufnahme 15 befestigt, wobei auf der Innenseite des "U" der Kontaktfläche 4' ebenfalls mittels eines wärmeleitfähigen Klebers 28 ein Substrat 29 der integrierten Schaltung 21' befestigt ist.

Der am Boden 27 anliegende Teil der Kontaktfläche 4' bildet dabei eine Zwischenschicht 30.

Die beiden parallelen Schenkel der Kontaktflächen 4' bilden Gegenanschlusslaschen 22, 22' die wie bei den Ausführungsbeispielen der Figuren 7 und 9 an den Anschlusslaschen 19, 19' in Anlage und durch Schweisspunkte 23, 23' thermisch leitend verbunden sind.

Auf dem Substrat 29 ist eine integrierte Schaltung 21' als Hybridschaltung mit nicht dargestellten Leiterbahnen angeordnet, die neben weiteren elektronischen Bauteilen auch ein Leistungshalbleiterelement aufweist.

Ein Teil der nicht dargestellten Leiterbahnen führen zu den den Signalanschlusslaschen 20, 20' gegenüberliegenden Randbereichen des Substrats 29. Blechartige Signalleiter 24, 24' sind mit ihrem einen Ende auf die jeweils ihnen zugeordneten Enden der Leiterbahnen des Substrats 29 aufgelötet.

Die anderen Enden der Signalleiter 24, 24' sind zu Signalanschlusslaschen 20, 20' rechtwinklig abgebogen und liegen an den ihnen jeweils zugeordneten Signalgegenanschlusslaschen 25, 25' an, mit denen sie durch Schweisspunkte 23, 23' elektrisch leitend verbunden sind.

Bei den Ausführungsbeispielen der Figuren 7 bis 9 erstrecken sich die Bereiche der Kontaktbleche 16, 16', die in dem Bauteil 13 angeordnet sind, nahe der Aussenwand des Bauteils 13, so dass sie mit dem grössten Teil ihrer Fläche von dem elektrisch isolierenden Werkstoff mit nur einer geringen Wandstärke 32 von etwa 1 bis 1,5 mm bedeckt sind. Damit ist eine gute wärmeabgabe nach aussen möglich.

Zur guten Verbindung der Kontaktbleche 16, 16' mit dem elektrisch isolierenden Werkstoff sind in den Kontaktblechen 16, 16' eine Vielzahl durchgehende Ausnehmungen 31 ausgebildet, die von dem elektrisch isolierenden Werkstoff ausgefüllt sind.

Bei den Ausführungsbeispielen der Figuren 7 und 9 dienen die Kontaktbleche 16, 16' sowohl zur Wärmeabfuhr als auch als elektrische Verbindung zu nicht dargestellten Steckerpins, während bei dem Ausführungsbeispiel der Figur 8 die Kontaktbleche 16, 16' nur zur Wärmeabfuhr dienen.

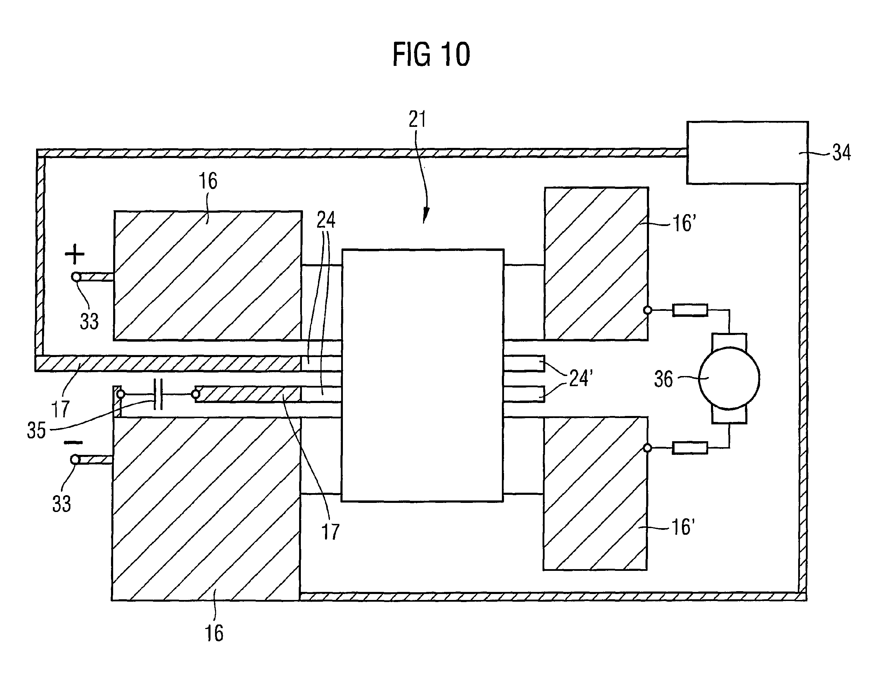

In Figur 10 ist die stilisierte Draufsicht eines Gitterblechs zu sehen, wie es bei den Ausführungsbeispielen der Figuren 7 und 9 verwandt ist.

Dabei weisen die Kontaktbleche 16 Steckerpins 33 auf und einer der Leiter 17 führt zu einem Positionserfassungssensor 34.

### Eine weitere Leiter 17 führt zur Spannungsversorgung 35.

Über die Kontaktbleche 16' ist ein Gleichstrommotor 36 von der integrierten Schaltung 21 ansteuerbar.

## Patentansprüche

1. Elektrische Baugruppe mit einer integrierten Schaltung, die mindestens ein Leistungshalbleiterelement und weitere elektronische Bauelemente aufweist, die durch von einem Gitterblech gebildete Leiter miteinander und mit Anschlüssen verbunden sind, wobei das Gitterblech (1, 3, 9) mindestens eine Kühlfläche (3) aufweist, die mit einer thermischen Kontaktflache (4) der mindestens einen integrierten Schaltung thermisch leitend verbunden ist, die eine größere Fläche als die thermische Kontaktfläche (4) der mindestens einen integrierten Schaltung aufweist und die breiter als die zur elektrischen Leitung verwendeten Teile (1) des Gitterblechs ist und wobei die Kühlfläche als thermisches Kontaktblech (16, 16') mit an seinem der integrierten Schaltung (21, 21') abgewandten Ende aus seiner Ebene abgebogener Anschlusslasche (19, 19') ausgebildet ist, an der ein Ende der Kontaktfläche (4, 4') in Anlage und thermisch leitend verbunden ist,
und wobei die Kontaktfläche (4, 4') eine Gegenanschlusslasche (22, 22') aufweist, die an der Anschlusslasche (19, 19') des thermischen Kontaktblechs (16, 16') in Anlage und mit der Anschlusslasche (19, 19')thermisch leitend verbunden ist, und wobei das Gitterblech signalführende Leiter (17, 17') aufweist, die an ihren der integrierten Schaltung (21, 21') zugewandten Enden aus ihrer Ebene abgebogene Signalanschlusslaschen (20, 20') aufweisen, an denen Enden die signalführenden Leiter (17, 17') in Anlage und elektrisch leitend verbunden sind
und wobei die Enden der signalführenden Leiter (17, 17') Signalgegenanschlusslaschen (25, 25') aufweisen, die an den Signalanschlusslaschen (20, 20') in Anlage und elektrisch leitend verbunden sind,
**dadurch gekennzeichnet, dass**
das thermische Kontaktblech (16, 16') in ein Bauteil (13) aus einem elektrisch isolierenden Werkstoff eingespritzt oder eingegossen ist, wobei das Bauteil (13) eine Aufnahme (15) aufweist, in die die integrierte Schaltung (21, 21') derart positioniert einsetzbar ist, dass Anschlusslasche (19, 19') und Gegenanschlusslasche (22, 22') sowie Signalanschlusslaschen (20, 20' ) und Signalgegenanschlusslaschen (25, 25') aneinander in Anlage sind.

2. Baugruppe nach Anspruch 1, **dadurch gekennzeichnet, dass** Anschlusslasche (19, 19') und Gegenanschlusslasche (22, 22') und/oder Signalanschlusslaschen (20, 20') und Signalgegenanschlusslaschen (25, 25') von der Ebene eines Bodens (27) der Aufnahme (15) weggerichtet abgebogen sind.

3. Baugruppe nach einem der Ansprüche 1 und 2, **dadurch gekennzeichnet, dass** das thermische Kontaktblech (16, 16') derart in das Bauteil (13) aus elektrisch isolierendem Werkstoff eingespritzt oder eingegossen ist, dass mindestens 50 % der Fläche des Kontaktblechs (16, 16') mit einer Wandstärke (32) des elektrisch isolierenden Werkstoffs von < 3 mm, insbesondere von < 1,5 mm bedeckt ist.

4. Baugruppe nach einem der Ansprüche 1 bis 3, **dadurch gekennzeichnet, dass** die signalführenden Leiter (17, 17') des Gitterblechs in das Bauteil (13) aus elektrisch isolierendem Werkstoff eingespritzt oder eingegossen sind, und die integrierte Schaltung (21, 21') derart positioniert in die Aufnahme (15) einsetzbar ist, daß einander zugeordnete Signalanschlusslaschen (20, 20') und Signalgegenanschlusslaschen (25, 25') aneinander in Anlage sind.

5. Baugruppe nach einem der Ansprüche 1 bis 4, **dadurch gekennzeichnet, dass** die integrierte Schaltung (21, 21') mit einer Begrenzungswand an dem Boden (27) der Aufnahme (15) in Anlage ist.

6. Baugruppe nach Anspruch 5, **dadurch gekennzeichnet, dass** das Bauteil (13) aus elektrisch isolierendem Werkstoff im Bereich des Bodens (27) der Aufnahme (15) eine Wandstärke von < 4 mm, insbesondere von < 2 mm besitzt.

7. Baugruppe nach einem der Ansprüche 5 und 6, **dadurch gekennzeichnet, dass** die integrierte Schaltung (21, 21') über eine Zwischenschicht (30) an dem Boden (27) der Aufnahme (15) in Anlage ist.

8. Baugruppe nach Anspruch 7, **dadurch gekennzeichnet, dass** die Zwischenschicht aus einem wärmeleitenden Klebstoff (26, 28), einer wärmeleitenden Klebefolie oder einer Wärmeleitpaste besteht.

9. Baugruppe nach Anspruch 3, **dadurch gekennzeichnet, dass** das thermische Kontaktblech (16, 16') in seinem von dem elektrisch isolierenden Werkstoff umschlossenen Bereich mit einer Ausnehmung oder einer Mehrzahl, insbesondere einer Vielzahl durchgehender Ausnehmungen (31) versehen ist.

10. Baugruppe nach einem der vorhergehenden Ansprüche, **dadurch gekennzeichnet, dass** die Kühlfläche (3) mit der Kontaktfläche (4) an mindestens zwei gegenüber liegenden Kanten fest verbunden ist und dass der an der Kontaktfläche (4) anliegende Flächenbereich (5) der Kühlfläche (3) gegen die Kontaktfläche (4) vorgespannt ist.

11. Baugruppe nach einem der vorhergehenden Ansprüche, **dadurch gekennzeichnet, dass** die Baugruppe einschließlich des Gitterblechs (1, 3) mit einem elektrisch isolierenden Werkstoff umkapselt ist.

12. Baugruppe nach Anspruch 11, **dadurch gekennzeichnet dass** die Kühlfläche. (3) mindestens teilweise nicht umkapselt ist.

13. Baugruppe nach Anspruch 11, **dadurch gekennzeichnet, dass** die Kühlfläche (3) mindestens teilweise mit einer dünneren Schicht umkapselt ist als die übrigen Teile der Baugruppe.

14. Baugruppe nach einem der vorhergehenden Ansprüche, **dadurch gekennzeichnet, dass** die weiteren elektronischen Bauelemente eine applikationsspezifische integrierte Schaltung (7) bilden.

15. Baugruppe nach einem der vorhergehenden Ansprüche, **dadurch gekennzeichnet, dass** ein Sensor (6) mit Hilfe der vom Gitterblech gebildeten Leiter angeschlossen ist.

16. Baugruppe nach einem der vorhergehenden Ansprüche, **dadurch gekennzeichnet, dass** die applikationsspezifische integrierte Schaltung (7) und die integrierte Schaltung in einem gemeinsamen Gehäuse integriert sind.

17. Baugruppe nach einem der vorhergehenden Ansprüche, **dadurch gekennzeichnet, dass** das Gitterblech (1, 3,9) in einem elektrisch isolierenden Halterahmen (8) gelagert ist.

18. Baugruppe nach einem der vorhergehenden Ansprüche, **dadurch gekennzeichnet, dass** Teile des Gitterblechs als elektrische Steckverbindungen (9) ausgeführt sind.

19. Baugruppe nach einem der vorhergehenden Ansprüche, **dadurch gekennzeichnet, dass** zwischen der Kontaktfläche (4) und dem diese berührenden Bereich (5) des Gitterblechs eine wärmeleitende Zwischenschicht aufgebracht ist.

20. Baugruppe nach einem der vorhergehenden Ansprüche, **dadurch gekennzeichnet, dass** die Anschlusslasche (19, 19') mit der Gegenanschlusslasche (22, 22') und/oder die Signalanschlusslaschen (20, 20') mit den Signalgegenanschlusslaschen (25, 25') durch Schweißen wie elektrisches Widerstandsschweissen oder Laserschweissen oder durch Löten verbunden sind.

21. Baugruppe nach einem der Ansprüche 1 bis 19, **dadurch gekennzeichnet, dass** die Anschlusslasche mit der Gegenanschlusslasche mittels elektrisch- und/oder wärmeleitfähigem Kleber verbunden ist.

22. Baugruppe nach einem der Ansprüche 1 bis 19 und 21, **dadurch gekennzeichnet, dass** die Signalanschlusslaschen mit den Signalgegenanschlusslaschen mittels einem elektrisch leitfähigen Kleber verbunden sind.

23. Baugruppe nach einem der vorhergehenden Ansprüche, **dadurch gekennzeichnet, dass** die integrierte Schaltung (21, 21') ein mit Kunststoff umkapseltes Leistungshalbleiterelement oder eine auf einem Substrat (29) angeordnete, Leistungshalbleiterelemente aufweisende Hybridschaltung ist.

24. Baugruppe nach Anspruch 23, **dadurch gekennzeichnet, dass** das Substrat ein Keramiksubstrat oder ein isoliertes Metallsubstrat oder eine Epoxi-Leiterplatte ist, auf dem das Leistungshalbleiterelement und elektronische Bauteile angeordnet, insbesondere aufgelötet oder insbesondere thermisch leitfähig aufgeklebt sind.

## Claims

1. Electrical assembly comprising an integrated circuit, which has at least one power semiconductor element and further electronic components, which are connected to one another and to connections by conductors formed by a leadframe, wherein the leadframe (1, 3, 9) has at least one cooling area (3), which is thermally conductively connected to a thermal contact area (4) of the at least one integrated circuit, which has a larger area than the thermal contact area (4) of the at least one integrated circuit and which is wider than the parts (1) of the leadframe which are used for electrical conduction, and wherein the cooling area is formed as a thermal contact plate (16, 16') with a connection lug (19, 19'), which is bent away from its plane at its end remote from the integrated circuit (21, 21') and at which one end of the contact area (4, 4') bears and is thermally conductively connected, and wherein the contact area (4, 4') has a mating connection lug (22, 22'), which bears on the connection lug (19, 19') of the thermal contact plate (16, 16') and is thermally conductively connected to the connection lug (19, 19') and wherein the leadframe has signal-carrying conductors (17, 17') having signal connection lugs (20, 20'), which are bent away from their plane at their ends facing the integrated circuit (21, 21') and at which ends the signal-carrying conductors (17, 17') bear and are electrically conductively connected, and wherein the ends of the signal-carrying conductors (17, 17') have signal mating connection lugs (25, 25'), which bear and are electrically conductively connected at the signal connection lugs (20, 20'), **characterized in that** the thermal contact plate (16, 16') is injection-molded or cast into a component (13) composed of an electrically insulating material, wherein the component (13) has a receptacle (15), into which the integrated circuit (21, 21') can be inserted in a manner positioned in such a way that connection lug (19, 19') and mating connection lug (22, 22') bear on one another and signal connection lugs (21, 21') and signal mating connection lugs (25, 25') bear on one another.

2. Assembly according to Claim 1, **characterized in that** connection lug (19, 19') and mating connection lug (22, 22') and/or signal connection lugs (20, 20') and signal mating connection lugs (25, 25') are bent away in a manner directed away from the plane of a bottom (27) of the receptacle (15).

3. Assembly according to either of Claims 1 and 2, **characterized in that** the thermal contact plate (16, 16') is injection-molded or cast into the component (13) composed of electrically insulating material in such a way that at least 50% of the area of the contact plate (16, 16') is covered with a wall thickness (32) of the electrically insulating material of < 3 mm, in particular of < 1.5 mm.

4. Assembly according to one of Claims 1 to 3, **characterized in that** the signal-carrying conductors (17, 17') of the leadframe are injection-molded or cast into the component (13) composed of electrically insulating material, and the integrated circuit (21, 21') can be inserted into the receptacle (15) in a manner positioned in such a way that mutually assigned signal connection lugs (20, 20) and signal mating connection lugs (25, 25') bear on one another.

5. Assembly according to one of Claims 1 to 4, **characterized in that** the integrated circuit (21, 21') bears with a boundary wall on the bottom (27) of the receptacle (15).

6. Assembly according to Claim 5, **characterized in that** the component (13) composed of electrically insulating material has a wall thickness of < 4 mm, in particular of < 2 mm, in the region of the bottom (27) of the receptacle (15).

7. Assembly according to either of Claims 5 and 6, **characterized in that** the integrated circuit (21, 21') bears on the bottom (27) of the receptacle (15) via an intermediate layer (30).

8. Assembly according to Claim 7, **characterized in that** the intermediate layer comprises a thermally conductive adhesive (26, 28), a thermally conductive adhesive film or a thermally conductive paste.

9. Assembly according to Claim 3, **characterized in that** the thermal contact plate (16, 16') is provided with a cutout or a plurality, in particular a multiplicity of continuous cutouts (31) in its region enclosed by the electrically insulating material.

10. Assembly according to one of the preceding claims, **characterized in that** the cooling area (3) is fixedly connected to the contact area (4) at at least two opposite edges, and **in that** the area region (5) of the cooling area (3) that bears on the contact area (4) is prestressed against the contact area (4).

11. Assembly according to one of the preceding claims, **characterized in that** the assembly including the leadframe (1, 3) is encapsulated with an electrically insulating material.

12. Assembly according to Claim 11, **characterized in that** the cooling area (3) is at least partially not encapsulated.

13. Assembly according to Claim 11, **characterized in that** the cooling area (3) is at least partially encapsulated with a thinner layer than the remaining parts of the assembly.

14. Assembly according to one of the preceding claims, **characterized in that** the further electronic components form an application specific integrated circuit (7).

15. Assembly according to one of the preceding claims, **characterized in that** a sensor (6) is connected with the aid of the conductors formed by the leadframe.

16. Assembly according to one of the preceding claims, **characterized in that** the application specific integrated circuit (7) and the integrated circuit are integrated in a common housing.

17. Assembly according to one of the preceding claims, **characterized in that** the leadframe (1, 3, 9) is mounted in an electrically insulating holding frame (8).

18. Assembly according to one of the preceding claims, **characterized in that** parts of the leadframe are embodied as electrical plug connections (9).

19. Assembly according to one of the preceding claims, **characterized in that** a thermally conductive intermediate layer is applied between the contact area (4) and the region (5) of the leadframe that touches said contact area.

20. Assembly according to one of the preceding claims, **characterized in that** the connection lug (19, 19') is connected to the mating connection lug (22, 22') and/or the signal connection lugs (20, 20') are connected to the signal mating connection lugs (25, 25') by welding such as electrical resistance welding or laser welding or by soldering.

21. Assembly according to one of Claims 1 to 19, **characterized in that** the connection lug is connected to the mating connection lug by means of electrically and/or thermally conductive adhesive.

22. Assembly according to one of Claims 1 to 19 and 21, **characterized in that** the signal connection lugs are connected to the signal mating connection lugs by means of an electrically conductive adhesive.

23. Assembly according to one of the preceding claims, **characterized in that** the integrated circuit (21, 21') is a plastic-encapsulated power semiconductor element or a hybrid circuit that is arranged on a substrate (29) and has power semiconductor elements.

24. Assembly according to Claim 23, **characterized in that** the substrate is a ceramic substrate or an insulated metal substrate or an epoxy printed circuit board, on which the power semiconductor element and electronic components are arranged, in particular soldered or in particular thermally conductively adhesively bonded.

## Revendications

1. Module électrique équipé d'un circuit intégré, qui comporte au moins un élément semi-conducteur de puissance et d'autres composants électroniques, lesquels sont reliés les uns avec les autres et avec des raccordements par un conducteur formé par une tôle perforée, où la tôle perforée (1, 3, 9) a au moins une surface de refroidissement (3), qui est liée en conduction thermique à une surface de contact thermique (4) du au moins un circuit intégré, qui a une surface supérieure à celle de la surface de contact thermique (4) du au moins un circuit intégré et qui est plus large que les parties (1) de la tôle perforée utilisées pour la conduction électrique
et où la surface de refroidissement est réalisée par une tôle de contact thermique (16, 16') avec languette de raccordement (19, 19'), laquelle est incurvée hors de son plan à son extrémité opposée au circuit intégré (21, 21') et s'applique sur l'une des extrémités de la surface de contact (4, 4') où elle y est en contact thermique et où la surface de contact (4, 4') a une languette de raccordement (22, 22') correspondante qui s'applique sur la languette de raccordement (19, 19') de la tôle de contact thermique (16, 16') et y est reliée en conduction thermique avec la languette de raccordement (19, 19') et où la tôle perforée comporte des conducteurs (17, 17') porteurs de signaux, qui ont, à leurs extrémités tournées vers le circuit imprimé (21, 21'), des languettes (20, 20') de raccordement de signaux incurvées hors de leur plan aux extrémités desquelles les conducteurs (17, 17') porteurs de signaux sont appliqués et reliés en contact électrique et où les extrémités des conducteurs (17, 17') porteurs de signaux ont des languettes correspondantes (25, 25') de raccordement de signaux lesquelles s'appliquent sur les languettes (20, 20') de raccordement de signaux et y sont reliées en contact électrique,
**caractérisé par le fait que** la tôle de contact thermique (16, 16') est injectée ou coulée dans une pièce (13) en matière électriquement isolante, où la pièce (13) comporte un logement (15) dans lequel il est possible d'insérer le circuit intégré (21, 21'), positionné de manière telle que les languettes (19, 19') de raccordement et les languettes correspondantes (22, 22') de raccordement, ainsi que les languettes (20, 20') de raccordement de signaux et les languettes correspondantes (25, 25') de raccordement de signaux s'appliquent respectivement les unes contre les autres.

2. Module électrique selon la revendication 1, **caractérisé par le fait que** les languettes (19, 19') de raccordement et les languettes correspondantes (22, 22') de raccordement et/ou les languettes (20, 20') de raccordement de signaux et les languettes correspondantes (25, 25') de raccordement de signaux sont incurvées hors du plan du fond (27) du logement (15).

3. Module électrique selon les revendications 1 et 2, **caractérisé par le fait que** la tôle de contact thermique (16, 16') est injectée ou coulée dans la pièce (13) en matière électriquement isolante de manière telle que au moins 50% de la surface de la tôle de contact (16, 16') est recouverte par une couche (32) de matière électriquement isolante de moins de 3 mm, notamment de moins de 1,5 mm.

4. Module électrique selon l'une des revendications 1 à 3, **caractérisé par le fait que** les conducteurs (17, 17') porteurs de signaux de la tôle perforée sont injectés ou coulés dans la pièce (13) en matière électriquement isolante et que le circuit intégré (21, 21') peut être inséré dans le logement (15), positionné de manière telle que des languettes (20, 20') de raccordement de signaux et des languettes (25, 25') de raccordement de signaux qui se correspondent sont appliquées les unes sur les autres.

5. Module électrique selon l'une des revendications 1 à 4, **caractérisé par le fait que** le circuit intégré (21, 21') est appliqué sur une paroi de limitation sur le fond (27) du logement (15).

6. Module électrique selon la revendication 5, **caractérisé par le fait que** la pièce (13) en matière électriquement isolante a, dans la zone du fond (27) du logement (15), une épaisseur de paroi inférieure à 4 mm, notamment inférieure à 2 mm.

7. Module électrique selon l'une des revendications 5 et 6, **caractérisé par le fait que** le circuit intégré (21, 21') est appliqué avec une couche intermédiaire (30) sur le fond (27) du logement (15).

8. Module électrique selon la revendication 7, **caractérisé par le fait que** la couche intermédiaire se compose d'une colle (26, 28) thermoconductrice, d'un film adhésif thermoconducteur ou d'une pâte thermoconductrice.

9. Module électrique selon la revendication 3, **caractérisé par le fait que** la tôle de contact thermique (16, 16') est dotée, dans sa partie enrobée par la matière électriquement isolante, d'un évidement ou d'une pluralité, notamment d'une multitude, d'évidements (31).

10. Module électrique selon l'une des revendications précédentes, **caractérisé par le fait que** la surface de refroidissement (3) est liée d'une façon fixe à la surface de contact (4) sur au moins deux arêtes se faisant face et que la partie (5) de la surface de refroidissement (3) appliquée sur la surface de contact (4) est appliquée avec une force de précontrainte sur la surface de contact (4).

11. Module électrique selon l'une des revendications précédentes, **caractérisé par le fait que** le module, y compris la tôle perforée (1, 3), est encapsulé avec une matière électriquement isolante.

12. Module électrique selon la revendication 11, **caractérisé par le fait que** la surface de refroidissement (3) n'est, au moins partiellement, pas encapsulée.

13. Module électrique selon la revendication 11, **caractérisé par le fait que** la surface de refroidissement (3) est encapsulée, au moins partiellement, avec une couche moins épaisse que les autres parties du module.

14. Module électrique selon l'une des revendications précédentes, **caractérisé par le fait que** les autres composants électroniques forment un circuit intégré (7) spécifique à une application.

15. Module électrique selon l'une des revendications précédentes, **caractérisé par le fait qu**'un capteur (6) est raccordé à l'aide des conducteurs formés par la tôle perforée.

16. Module électrique selon l'une des revendications précédentes, **caractérisé par le fait que** le circuit intégré (7) spécifique à une application et le circuit intégré sont intégrés dans un boîtier commun.

17. Module électrique selon l'une des revendications précédentes, **caractérisé par le fait que** la tôle perforée (1, 3, 9) est montée dans un cadre porteur électriquement isolant.

18. Module électrique selon l'une des revendications précédentes, **caractérisé par le fait que** des parties de la tôle perforée sont réalisées sous forme de liaisons électriques enfichables.

19. Module électrique selon l'une des revendications précédentes, **caractérisé par le fait qu**'une couche intermédiaire thermoconductrice est insérée entre la surface de contact (4) et la partie de la tôle perforée qui est en contact avec elle.

20. Module électrique selon l'une des revendications précédentes, **caractérisé par le fait que** les languettes (19, 19') de raccordement et les languettes correspondantes (22, 22') de raccordement et/ou les languettes (20, 20') de raccordement de signaux et les languettes correspondantes (25, 25') de raccordement de signaux sont liées respectivement les unes aux autres par soudage, par exemple par soudage à résistance électrique ou par soudage au laser ou par brasage.

21. Module électrique selon l'une des revendications 1 à 19, **caractérisé par le fait que** la languette de raccordement est liée à la languette de raccordement correspondante au moyen d'une colle électriquement conductrice et /ou thermoconductrice.

22. Module électrique selon l'une des revendications 1 à 19 et 21, **caractérisé par le fait que** les languettes de raccordement de signaux sont liées aux languettes correspondantes de raccordement de signaux au moyen d'une colle électriquement conductrice.

23. Module électrique selon l'une des revendications précédentes, **caractérisé par le fait que** le circuit intégré (21, 21') est un élément semi-conducteur de puissance encapsulé de matière plastique ou un circuit hybride comportant des éléments semi-conducteurs de puissance disposés sur un substrat (29).

24. Module électrique selon la revendication 23, **caractérisé par le fait que** le substrat est un substrat en céramique ou un substrat métallique isolé ou un circuit imprimé en résine époxyde, sur lequel sont montés, notamment soudés ou notamment collés d'une façon thermoconductible, l'élément semi-conducteur de puissance et les composants électroniques.
